# EUROPÄISCHE PATENTSCHRIFT

(11) **EP 1 212 782 B1**
(45) Veröffentlichungstag und Bekanntmachung des Hinweises auf die Patenterteilung: **24.01.2007**
(21) Anmeldenummer: 00972582.1
(22) Anmeldetag: 06.09.2000
(51) Int. Cl.: H01L 21/00

(54) **VERFAHREN ZUR HERSTELLUNG EINER INTEGRIERTEN SCHALTUNGSANORDNUNG MIT MINDESTENS EINEM KONDENSATOR**
METHOD FOR THE PRODUCTION OF AN INTEGRATED CIRCUIT ARRANGEMENT WITH AT LEAST A CAPACITOR
PROCEDE DE PRODUCTION D'UN ENSEMBLE CIRCUIT INTEGRE COMPRENANT AU MOINS UN CONDENSATEUR

(30) Priorität: 07.09.1999 DE 19942680
(43) Veröffentlichungstag der Anmeldung: 12.06.2002
(73) Patentinhaber: Infineon Technologies AG, 81669 München (DE)
(72) Erfinder: SCHUMANN, Dirk, 01097 Dresden (DE); SELL, Bernhard, 01099 Dresden (DE); WILLER, Josef, 85521 Riemerling (DE)
(74) Vertreter: Kottmann, Heinz Dieter
(86) Internationale Anmeldenummer: PCT/DE2000/003123
(87) Internationale Veröffentlichungsnummer: WO 2001/018849

(56) Entgegenhaltungen:
- EP-A- 0 386 947
- DE-A- 19 720 202
- US-A- 5 124 766
- US-A- 5 394 000
- US-A- 5 604 148
- US-A- 5 763 305
- PATENT ABSTRACTS OF JAPAN vol. 1997, no. 05, 30. Mai 1997 (1997-05-30) & JP 09 017971 A (MITSUBISHI ELECTRIC CORP), 17. Januar 1997 (1997-01-17)

## Beschreibung

Die Erfindung betrifft ein Verfahren zur Erzeugung einer integrierten Schaltungsanordnung mit mindestens einem Kondensator nach dem Oberbegriff des Patentanspruches 1.

Eine integrierte Schaltungsanordnung mit einer Speicherzellenanordnung, bei der eine Speicherzelle einen Transistor und einen Kondensator umfasst, wird beispielsweise in EP 0 415 530 B1 beschrieben. Der Kondensator ist als Stapelkondensator ausgeführt und umfasst eine Polysiliziumstruktur mit mehreren, im Wesentlichen parallel übereinander angeordneten Polysiliziumschichten, die über mindestens eine seitliche Stütze miteinander verbunden sind. Die Polysiliziumstruktur wird durch alternierende Abscheidung von Polysiliziumschichten und selektiv dazu ätzbaren SiO₂-Schichten auf der Oberfläche des Substrats, Strukturierung dieser Schichten, Erzeugung von Flankenabdeckungen (Spacer) aus Polysilizium an mindestens einer Flanke der Schichtstruktur und selektives Herausätzen der SiO₂-Schichten gebildet. Die Polysiliziumstruktur wirkt als erste Kondensatorelektrode des Kondensators. Die Flächen der Polysiliziumstruktur werden mit einem Kondensatordielektrikum versehen. Anschließend wird eine zweite Kondensatorelektrode des Kondensators erzeugt, die an das Kondensatordielektrikum angrenzt. Trotz kleinem Platzbedarf des Kondensators, das heißt kleiner Fläche der Projektion des Kondensators auf die Substratoberfläche weist der Kondensator eine große Kapazität auf, da die Oberfläche der Polysiliziumstruktur aufgrund der übereinander angeordneten Schichten sehr groß ist.

Weiterhin sind Verfahren der eingangs genannten Art beispielsweise aus PATENT ABSTRACTS OF JAPAN Bd. 1997, Nr. 05, 30. Mai 1997 & JP-A-09-17971 oder US-A-5 604 148 bekannt.

Der Erfindung liegt das Problem zugrunde, ein Verfahren zur Herstellung einer integrierten Schaltungsanordnung mit mindestens einem Kondensator anzugeben, der im Vergleich zum Stand der Technik einen kleineren Platzbedarf bei zugleich hoher Kapazität aufweisen kann.

Diese Aufgabe wird erfindungsgemäß durch ein Verfahren mit den Merkmalen des Patentanspruches 1 gelöst. Vorteilhafte Weiterbildungen der Erfindung ergeben sich aus den Unteransprüchen.

Bei einer integrierten Schaltungsanordnung mit mindestens einem Kondensator ist der Kondensator über einer Oberfläche eines Substrats angeordnet. Eine y-Achse verläuft senkrecht zur Oberfläche des Substrats. Eine erste Kondensatorelektrode des Kondensators weist einen Mittelteil auf, der sich von einer ersten Höhe zu einer darüber befindlichen zweiten Höhe bezüglich der y-Achse erstreckt. Der Mittelteil ist mit einem darunter angeordneten Bauelement der integrierten Schaltungsanordnung verbunden. Die erste Kondensatorelektrode weist mindestens einen Seitenteil auf, der neben dem Mittelteil angeordnet ist und von ihm beabstandet ist. Der Seitenteil erstreckt sich von einer dritten Höhe, die zwischen der ersten Höhe und der zweiten Höhe liegt, bis zur zweiten Höhe. Die erste Kondensatorelektrode weist einen oberen Teil auf, der auf dem Seitenteil und dem Mittelteil angeordnet ist und diese miteinander verbindet. Die erste Kondensatorelektrode ist mit einem Kondensatordielektrikum versehen. Eine zweite Kondensatorelektrode grenzt an das Kondensatordielektrikum an.
Bei dem Verfahren zur Erzeugung einer integrierten Schaltungsanordnung mit mindestens einem Kondensator wird der Kondensator über einer Oberfläche eines Substrats erzeugt. Eine y-Achse verläuft senkrecht zur Oberfläche des Substrats. Ein Mittelteil einer ersten Kondensatorelektrode des Kondensators wird so erzeugt, dass er sich von einer ersten Höhe bis zu einer darüber befindlichen zweiten Höhe bezüglich der y-Achse erstreckt. Ein Bauelement der integrierten Schaltungsanordnung wird erzeugt und mit dem darüber erzeugten Mittelteil verbunden. Mindestens ein Seitenteil der ersten Kondensatorelektrode wird so erzeugt, so dass er neben dem Mittelteil angeordnet ist und von ihm beabstandet ist. Der Seitenteil wird so erzeugt, dass er sich von einer dritten Höhe, die zwischen der ersten Höhe und der zweiten Höhe liegt, bis zur zweiten Höhe erstreckt. Ein oberer Teil der ersten Kondensatorelektrode wird so erzeugt, daß er auf dem Seitenteil und dem Mittelteil angeordnet ist und diese miteinander verbindet. Die erste Kondensatorelektrode wird mit einem Kondensatordielektrikum versehen. Eine zweite Kondensatorelektrode wird so erzeugt, daß sie an das Kondensatordielektrikum angrenzt.

Da das Kondensatordielektrikum sämtliche Flächen der ersten Kondensatorelektrode ab mindestens der dritten Höhe bedeckt, und die zweite Kondensatorelektrode das Kondensatordielektrikum bedeckt, ist auch zwischen dem seitlichen Teil und dem Mittelteil ein Teil der zweiten Kondensatorelektrode angeordnet.

Durch die Aussparung der ersten Kondensatorelektrode zwischen dem Mittelteil und dem Seitenteil, wird die Oberfläche der ersten Kondensatorelektrode, die die Kapazität des Kondensators stark beeinflußt, vor allem durch seitliche Flächen des Seitenteils und des Mittelteils im Vergleich zu einer Kondensatorelektrode ohne Aussparung vergrößert, ohne daß sich der Platzbedarf des Kondensators vergrößert. Je größer der Abstand zwischen der dritten Höhe und der ersten Höhe ist, umso größer ist die Kapazität des Kondensators.

Eine besonders große Kapazität des Kondensators wird erzielt, wenn die dritte Höhe näher zur ersten Höhe als zur zweiten Höhe liegt.

Die erste Kondensatorelektrode wird mit Hilfe eines Abstandhalters erzeugt. Dazu wird über dem Substrat eine Hilfsschicht erzeugt. Der Mittelteil wird erzeugt, indem in der Hilfsschicht eine Vertiefung erzeugt und leitendem Material gefüllt wird. Der Abstandhalter wird so gebildet, daß er an seitliche Flächen des Mittelteils angrenzt und unterhalb der dritten Höhe seitlich vom Mittelteil weg herausragt. Der obere Teil und der Seitenteil werden so erzeugt, daß sie an den Abstandhalter angrenzen. Der obere Teil grenzt von oben an den Abstandhalter an, während der Seitenteil seitlich an den Abstandhalter angrenzt und auch von oben an den Teil des Abstandhalters angrenzt, der unterhalb der dritten Höhe seitlich vom Mittelteil weg herausragt. Der Teil des Abstandhalters, der an die seitlichen Flächen des Mittelteils angrenzt, ist folglich zwischen dem Mittelteil und dem Seitenteil angeordnet, während der Teil des Abstandhalters, der unterhalb der dritten Höhe seitlich vom Mittelteil weg hervorsteht, unter dem Seitenteil angeordnet ist, und er kann seitlich unter dem Seitenteil herausragen. Da dieser Teil zumindest seitlich und möglicherweise auch teilweise von oben nicht durch den Seitenteil bedeckt wird, kann der Abstandhalter durch isotropes Ätzen selektiv zur ersten Kondensatorelektrode entfernt werden. Anschließend werden das Kondensatordielektrikum und die zweite Kondensatorelektrode erzeugt.

Um den Platzbedarf des Kondensators zu erniedrigen, ist es vorteilhaft, den Teil des Abstandhalters, der an die seitlichen Flächen des Mittelteils angrenzt, mit besonders kleiner horizontaler Dicke zu erzeugen. Vorzugsweise ist die horizontale Dicke dieses Teils des Abstandhalters homogen, das heißt, daß dieser Teil des Abstandhalters überall dieselbe Dicke aufweist.

Zur Verringerung des Platzbedarfs des Kondensators ist es vorteilhaft, den Mittelteil und den Seitenteil so zu erzeugen, daß deren seitliche Flächen im wesentlichen parallel zur y-Achse sind.

Bei homogener horizontaler Dicke des Teils des Abstandhalters, der an die seitlichen Flächen des Mittelteils angrenzt, folgen die seitlichen Flächen des Seitenteils, die dem Mittelteil zugewandt sind, dem Verlauf der seitlichen Flächen des Mittelteils in im wesentlichen konstanten Abstand zu den seitlichen Flächen des Mittelteils. Dieser Abstand ist nämlich gleich der horizontalen Dicke des Abstandhalters.

Eine besonders große Kapazität wird erzielt, wenn der Seitenteil den Mittelteil seitlich umgibt.

Es können aber auch z. B. zwei Seitenteile vorgesehen sein, die nicht aneinander angrenzen.

Es können mehr als ein Seitenteil vorgesehen sein, die unterschiedlich große Abstände vom Mittelteil aufweisen. Jeder der Seitenteile kann den Mittelteil seitlich umgeben. Ein erster Seitenteil, der weiter entfernt vom Mittelteil angeordnet ist als ein zweiter Seitenteil, umgibt auch den zweiten Seitenteil seitlich. Die Seitenteile sind ineinandergeschachtelt.

Im Folgenden wird ein erstes Verfahren beschrieben, bei dem ein Abstandhalter verwendet wird, dessen Teil, der an die seitlichen Flächen des Mittelteils angrenzt, eine homogene horizontale Dicke aufweist.

Die Hilfsschicht wird nach Erzeugung des Mittelteils nicht tiefer als bis zur dritten Höhe geätzt. Durch Abscheiden und Rückätzen von Material wird als Teil des Abstandhalters ein Spacer an freiliegenden Teilen der seitlichen Flächen des Mittelteils erzeugt. Der Spacer reicht bis maximal zur zweiten Höhe, so daß mindestens eine obere horizontale Fläche des Mittelteils freiliegt. Der als Spacer erzeugte Teil des Abstandhalters grenzt folglich an die seitlichen Flächen des Mittelteils an und weist eine im wesentlichen homogene horizontale Dicke auf. Als weiterer Teil des Abstandhalters dient Material unterhalb der dritten Höhe. Anschließend wird leitendes Material durch selektive Epitaxie so aufgewachsen, daß das leitende Material auf dem Mittelteil aber nicht auf dem Abstandhalter aufwächst. Weiteres leitendes Material wird abgeschieden und anschließend rückgeätzt, so daß aus dem epitaktisch aufgewachsenen leitenden Material der obere Teil und aus dem abgeschiedenen leitenden Material der Seitenteil erzeugt werden und der Teil des Abstandhalters, der seitlich unter dem Seitenteil herausragt, freigelegt wird. Da das leitende Material auf der oberen Fläche des Mittelteils aufgrund der selektiven Epitaxie besonders dick ist, bleibt beim Rückätzen bis zum Freilegen des Abstandhalters leitendes Material auf dem Mittelteil übrig, das im wesentlichen den oberen Teil bilden kann.

Das Material, aus dem der als Spacer erzeugte Teil des Abstandhalters erzeugt wird, kann weiter rückgeätzt werden als die Dicke, in der das Material abgeschieden wird. In diesem Fall werden auch obere Bereiche der seitlichen Flächen des Mittelteils freigelegt, auf denen das leitende Material aufwachsen kann.

Beim Rückätzen des Materials kann auch das Material, das unterhalb der dritten Höhe, d.h. unterhalb des entfernten Teils der Hilfsschicht angeordnet ist, angegriffen werden. Dies ist insbesondere dann der Fall, wenn es sich um dasselbe Material handelt. Da der Seitenteil auf dem Abstandhalter angeordnet sein soll und sich der Seitenteil ab der dritten Höhe nach oben erstreckt, wird die dritte Höhe dadurch definiert, wie tief die Hilfsschicht geätzt wird und wie weit das Material des Spacers rückgeätzt wird.

Als leitendes Material eignet sich beispielsweise Wolfram oder Wolframsilizid, wenn der Mittelteil ebenfalls aus Wolfram oder Wolframsilizid besteht. Es ist jedoch jedes leitende Material geeignet, das auf dem Mittelteil aber nicht auf dem Abstandhalter aufwächst.

Der Abstandhalter besteht beispielsweise aus Siliziumnitrid oder aus SiO₂.

Ein besonders kleiner Platzbedarf des Kondensators wird erzielt, wenn die Vertiefung mit Hilfe einer Maske erzeugt wird, deren Öffnung Abmessungen aufweist, die der minimalen, in der verwendeten Technologie herstellbaren Strukturgröße F entspricht. Der durch Auffüllen der Vertiefung erzeugte Mittelteil weist folglich auch eine Breite oder/und eine Länge auf, die der Strukturgröße F entspricht.

Ein noch kleinerer Platzbedarf kann erzielt werden, wenn nach Ätzen der Hilfsschicht der Mittelteil durch isotropes Ätzen verengt wird. Die Breite und/oder die Länge des Mittelteils kann in diesem Fall sogar kleiner als die Strukturgröße F sein.

Alternativ kann die für die Vertiefung verwendete Maske durch Spacer vergrößert werden, so daß die Öffnung der Maske Abmessungen aufweist, die kleiner als die Strukturgröße F ist. In diesem Fall weist der Mittelteil auch ohne isotropes Ätzen besonders kleine horizontale Abmessungen auf.

Da so ein Mittelteil einen horizontalen Querschnitt aufweist, der kleiner als F² ist, kann der gesamte Kondensator einen Platzbedarf von nur F² aufweisen.

Zur Erzeugung einer solchen vergrößerten Maske, wird nach Erzeugung der Maske mit Hilfe photolithographischer Prozeßschritte Material abgeschieden und rückgeätzt, so daß in der Öffnung der Maske Spacer erzeugt werden, die die Maske vergrößern, das heißt die Öffnung verengen. Alternativ kann eine Öffnung mit kleinerem Querschnitt als F² mit der CARL (chemical amplification of resist lines) Technologie hergestellt werden. Hierbei wird die Maske durch Sililierung vergrößert.

Sollen mehr als ein Seitenteil erzeugt werden, so kann nach Erzeugung des Seitenteils ein weiterer Abstandhalter analog zum Abstandhalter erzeugt werden. Der weitere Abstandhalter grenzt seitlich an den Seitenteil an. Anschließend wird wieder leitendes Material durch selektive Epitaxie aufgewachsen, so daß der obere Teil vergrößert wird. Wie bei der Erzeugung des Seitenteils wird weiteres leitendes Material abgeschieden und rückgeätzt, so daß ein weiterer Seitenteil erzeugt wird. Diese Abfolge von Prozeßschritten kann wiederholt werden, so daß zusätzliche Seitenteile erzeugt werden.

Im folgenden wird eine zweite Möglichkeit zur Erzeugung einer integrierten Schaltungsanordnung mit mindestens einem Kondensator beschrieben, bei der ein Abstandhalter verwendet wird, dessen Teil, der an die seitlichen Flächen des Mittelteils angrenzt, eine homogenen horizontale Dicke aufweist.

Auf der Hilfsschicht wird eine weitere Hilfsschicht erzeugt. Die Vertiefung durchtrennt die weitere Hilfsschicht. Nach Erzeugung der Vertiefung wird die weitere Hilfsschicht isotrop geätzt, so daß die Vertiefung im Bereich der weiteren Hilfsschicht erweitert wird. Durch Füllen der Vertiefung mit dem leitenden Material wird der Mittelteil im Bereich der Hilfsschicht und ein Teil des oberen Teils im Bereich der weiteren Hilfsschicht erzeugt. Der obere Teil ist also auf dem Mittelteil angeordnet und überragt den Mittelteil seitlich in allen Richtungen. Die weitere Hilfsschicht und die Hilfsschicht werden selektiv zum Teil des oberen Teils anisotrop bis zur dritten Höhe geätzt, so daß unter dem Teil des oberen Teils aus der Hilfsschicht mindestens ein Teil des Abstandhalters gebildet wird. Dieser Teil des Abstandhalters grenzt folglich an die seitlichen Flächen des Mittelteils an und weist aufgrund der Erzeugung des Teils des oberen Teils mit Hilfe von isotropem Ätzen eine im wesentlichen homogene horizontale Dicke auf. Der Seitenteil und ein restlicher Teil des oberen Teils wird anschließend in Form eines Spacers durch Abscheiden und Rückätzen von Material erzeugt. Teile des Spacers, die seitlich an den Teil des oberen Teils angrenzen und auf derselben Höhe wie der Teil des oberen Teils liegen, bilden den restlichen Teil des oberen Teils.

Der Abstandhalter wird selbstjustiert, das heißt ohne zu justierende Maske, unterhalb des oberen Teils und angrenzend an den Mittelteil erzeugt. Der Abstand zwischen dem Rand der nichterweiterten Vertiefung und dem Rand der erweiterten Vertiefung bestimmt die Dicke des Teils des Abstandhalters, der an die seitlichen Flächen des Mittelteils angrenzt. Da das isotrope Ätzen der weiteren Hilfsschicht Material ausgehend von der ursprünglichen Vertiefung gleichmäßig entfernt, ist die Dicke des Abstandhalters homogen.

Auf die weitere Hilfsschicht kann verzichtet werden, wenn zum Auffüllen der Vertiefung leitendes Material abgeschieden wird und anschließend mit Hilfe einer Maske so strukturiert wird, daß auf der Hilfsschicht um den Mittelteil herum ebenfalls leitendes Material übrig bleibt und den Teil des oberen Teils bildet. In diesem Fall kann aufgrund von Justierungenauigkeiten des Maske nicht für eine homogene horizontale Dicke des Teils des Abstandhalters garantiert werden. Damit der Teil des oberen Teils mit im wesentlichen senkrechten Kanten erzeugt werden kann, ist es vorteilhaft, auf der weiteren Hilfsschicht eine Maskenschicht zu erzeugen, die durch die Vertiefung durchtrennt wird. Die Maskenschicht wird erst nach dem isotropen Ätzen der weiteren Hilfsschicht und vor dem Füllen der Vertiefung entfernt. Dies hat auch den Vorteil, daß die Dicke des oberen Teils durch die Dicke der weiteren Hilfsschicht bestimmt wird. Wird auf die Maskenschicht verzichtet, so muß zum Erzielen derselben Dicke des oberen Teils eine dickere weitere Hilfsschicht abgeschieden werden, da die Hilfsschicht beim isotropen Ätzen auch von ober her abgetragen wird.

Insbesondere zur Erzeugung mehrerer Seitenteile ist folgendes Verfahren geeignet:
Die Vertiefung wird in der Hilfsschicht so erzeugt, daß sie zunächst bis zur dritten Höhe reicht. Eine Oberfläche der Hilfsschicht liegt höher als die erste Höhe. Anschließend werden Schichten aus alternierend leitendem Material und isolierendem Material abgeschieden ohne die Vertiefung zu füllen und rückgeätzt. Durch das Rückätzen des leitenden Materials werden Seitenteile und durch das Rückätzen des isolierenden Materials werden Teile von Abstandhaltern erzeugt. Die Anzahl der Schichten aus leitendem Material ist gleich der Anzahl der erzeugten Seitenteile. Ein nach dem Rückätzen der letzten Schicht aus isolierendem Material freigelegter Teil des Bodens des Vertiefung wird anschließend bis mindestens zur ersten Höhe tiefer geätzt. Der noch nicht gefüllte Teil der Vertiefung wird mit leitendem Material gefüllt, indem leitendes Material abgeschieden und bis oberhalb der ersten Höhe rückgeätzt wird. Leitendes Material, das von dem innersten Abstandhalter umgeben ist, bildet den Mittelteil. Leitendes Material, das auf den Seitenteilen, den Abstandhaltern und dem Mittelteil angeordnet ist, bildet den oberen Teil. Vorzugsweise werden später abgeschiedene Schichten weiter rückgeätzt als vorher abgeschiedene Schichten, damit ein Kontakt zwischen dem oberen Teil und den Seitenteilen besser ist.

Als Teil des Abstandhalters, der seitlich vom Mittelteil wegsteht, ist z. B. ein Teil der Hilfsschicht geeignet.

Zur genauen Einstellung der Ätztiefe beim Ätzen der Hilfsschicht ist es vorteilhaft, über dem Substrat eine Stopschicht zu erzeugen, deren obere Fläche im Bereich der dritten Höhe liegt, und darüber die Hilfsschicht zu erzeugen. Die Vertiefung durchtrennt die Stopschicht. Der Teil des Abstandhalters, der seitlich vom Mittelteil wegsteht, ist folglich die Stopschicht. Die Stopschicht wirkt als Ätzstop beim Ätzen der Hilfsschicht. Die Stopschicht kann auch als Ätzstop beim Rückätzen des Materials des Seitenteils wirken. In diesem Fall liegt eine obere Fläche der Stopschicht in der dritten Höhe.

Die Stopschicht, der Teil des Abstandhalters, der an die seitlichen Flächen des Mittelteils angrenzt und die Hilfsschicht bestehen beispielsweise aus Siliziumnitrid oder SiO₂. Um selektives Ätzen zu ermöglichen ist es vorteilhaft, wenn die Stopschicht aus einem anderen Material als die Hilfsschicht besteht.

Die integrierte Schaltungsanordnung kann eine DRAM-Zellenanordnung sein. Beispielsweise ist das Bauelement ein Transistor, der zusammen mit dem Kondensator eine Speicherzelle bildet.

Eine besonders hohe Packungsdichte der DRAM-Zellenanordnung läßt sich erzielen, wenn die Kondensatoren von Speicherzellen in Reihen und Spalten angeordnet sind. Damit die Seitenteile, die im vertikalen Querschnitt betrachtet zwischen den Mittelteilen angeordnet sind, mehr Platz haben, ist es vorteilhaft, den Mittelteil so zu erzeugen, daß eine Breite des Mittelteils, die parallel zu der Richtung der Reihen ist, kleiner ist als ein Abstand zwischen benachbarten Mittelteilen von Kondensatoren, die entlang der Reihen zueinander benachbart sind. Entsprechend ist vorzugsweise eine Länge des Mittelteils, die parallel zu der Richtung der Spalten ist, kleiner als ein Abstand zwischen Mittelteil von Kondensatoren, die entlang der Spalten zueinander benachbart sind.

Ein horizontaler Querschnitt des Mittelteils kann beispielsweise rechteckig, insbesondere quadratisch, oder kreisförmig sein.

Die Länge bzw. Breite des Mittelteils kann kleiner als die Strukturgröße F betragen. Für den Fall des kreisförmigen Querschnitts ist die Breite bzw. die Länge des Mittelteils der Durchmesser des Querschnitts. Der Platzbedarf pro Speicherzelle kann 4F² betragen.

Im folgenden werden Ausführungsbeispiele der Erfindung anhand der Figuren näher erläutert.
- Figur 1: zeigt einen Querschnitt durch ein Substrat, nachdem Transistoren, ein Zwischenoxid, eine Stopschicht, eine Hilfsschicht und Vertiefungen erzeugt wurden.
- Figur 2: zeigt den Querschnitt aus Figur 1, nachdem Mittelteile von ersten Kondensatorelektroden von Kondensatoren, Kontakte und Abstandhalter erzeugt wurden.
- Figur 3: zeigt den Querschnitt aus Figur 2, nachdem obere Teile der ersten Kondensatorelektroden erzeugt wurden und Wolfram abgeschieden wurde.
- Figur 4: zeigt den Querschnitt aus Figur 3, nachdem Seitenteile der ersten Kondensatorelektroden erzeugt wurden.
- Figur 5: zeigt den Querschnitt aus Figur 3, nachdem die Abstandhalter entfernt wurden und ein Kondensatordielektrikum und eine zweite gemeinsame Kondensatorelektrode der Kondensatoren erzeugt wurden.
- Figur 6: zeigt einen Querschnitt durch ein zweites Substrat, nachdem Transistoren, ein Zwischenoxid, eine Stopschicht, eine Hilfsschicht, eine weitere Hilfsschicht, eine Maskenschicht und Vertiefungen erzeugt wurden.
- Figur 7: zeigt den Querschnitt aus Figur 6, nachdem Mittelteile, Seitenteile und obere Teile von ersten Kondensatorelektroden von Kondensatoren, Kontakte und Abstandhalter erzeugt wurden und die Maskenschicht, die weitere Hilfsschicht und die Hilfsschicht entfernt wurden.
- Figur 8: zeigt den Querschnitt aus Figur 7, nachdem die Abstandhalter entfernt wurden und ein Kondensatordielektrikum und eine gemeinsame zweite Kondensatorelektrode der Kondensatoren erzeugt wurden.

- Figur 9: zeigt einen Querschnitt durch ein drittes Substrat, nachdem Transistoren, ein Zwischenoxid, eine Stopschicht, eine Hilfsschicht, Vertiefungen, Seitenteile von ersten Kondensatorelektroden von Kondensatoren und erste Teile von Abstandhalter erzeugt wurden.
- Figur 10: zeigt den Querschnitt aus Figur 9, nachdem die Hilfsschicht und die Abstandhalter entfernt wurden und Mittelteile und obere Teile der ersten Kondensatorelektroden, Kontakte, ein Kondensatordielektrikum und eine gemeinsame zweite Kondensatorelektrode der Kondensatoren erzeugt wurden.

Die Figuren sind nicht maßstabsgetreu.

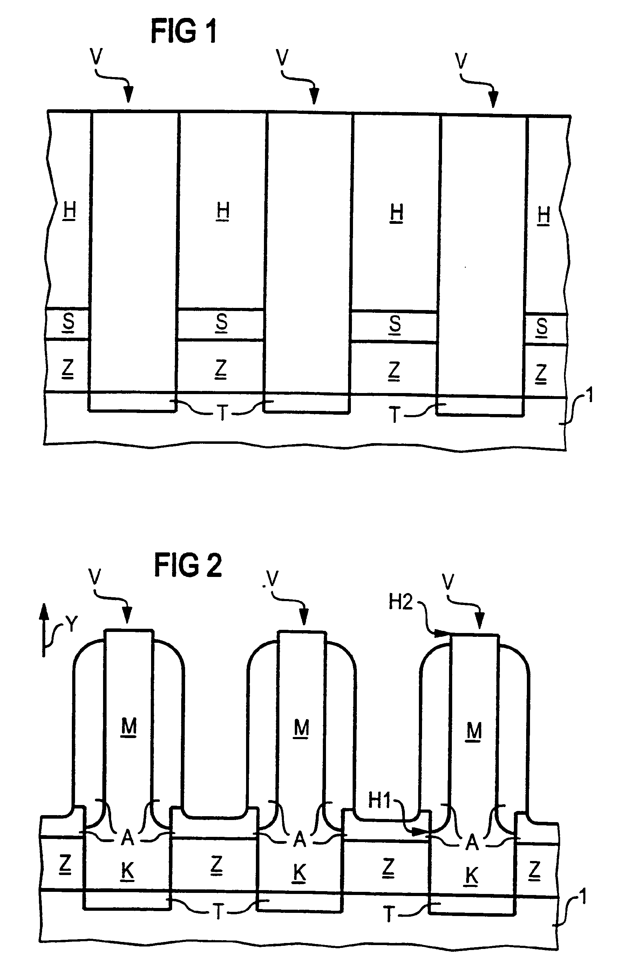

In einem ersten Ausführungsbeispiel ist als Ausgangsmaterial ein erstes Substrat 1 aus Silizium vorgesehen. Im Bereich einer Oberfläche des ersten Substrats 1 werden Transistoren T gemäß dem Stand der Technik erzeugt. Die Transistoren T sind schematisch in Figur 1 dargestellt.

Anschließend wird auf dem ersten Substrat 1 ein ca. 200 nm dickes Zwischenoxid Z aus SiO₂ erzeugt (siehe Figur 1). Darüber wird eine Stopschicht S erzeugt, indem Siliziumnitrid in einer Dicke von ca. 30nm abgeschieden wird (siehe Figur 1). Darüber wird eine Hilfsschicht H erzeugt, indem BPSG (Bor-Phosphor-Silikat-Glas) in einer Dicke von ca. 800 nm abgeschieden wird (siehe Figur 1).

Durch ein photolithographisches Verfahren werden Vertiefungen V erzeugt, die die Hilfsschicht H, die Stopschicht S und das Zwischenoxid Z durchtrennen und bis zu den Transistoren T reichen (siehe Figur 1). Als Ätzmittel ist z. B. CF₄ + CHF₃ geeignet. Die Vertiefungen V weisen einen quadratischen horizontalen Querschnitt auf, dessen Seitenlänge ca. 100nm beträgt. Die Vertiefungen V sind in Reihen und Spalten angeordnet. Entlang der Spalten zueinander benachbarte Vertiefungen V weisen einen Abstand von ca. 100nm voneinander auf. Entlang der Reihen zueinander benachbarte Vertiefungen V weisen einen Abstand von ca. 100nm voneinander auf.

Anschließend wird Wolfram in einer Dicke von ca. 100 nm abgeschieden und durch chemisch-mechanisches Polieren planarisiert, bis die Hilfsschicht H freilegt wird (siehe Figur 1).

Die Hilfsschicht H wird mit z. B. H₂SO₄ + HF entfernt. Anschließend wird Wolfram ca. 25nm weit isotrop mit z. B. heißer H₂O₂ selektiv zu Siliziumnitrid geätzt. Aus dem Wolfram entstehen dadurch Mittelteile M von ersten Kondensatorelektroden von Kondensatoren, die sich von einer ersten Höhe H1 bezüglich einer y-Achse y, die senkrecht zur Oberfläche des Substrats 1 verläuft, bis zu einer zweiten Höhe H2 bezüglich der y-Achse y erstrecken, und Kontakte K. Die erste Höhe H1 liegt ca. 25nm unterhalb einer oberen Oberfläche der Stopschicht S. Die zweite Höhe H2 liegt ca. 775 nm oberhalb der oberen Oberfläche der Stopschicht S. Die Mittelteile M sind auf den Kontakten K angeordnet, die die Mittelteile M mit Source/Drain-Gebieten der Transistoren T verbinden. Die Kontakte K erstrecken sich von den Transistoren T bis zur ersten Höhe H1 und weisen einen größeren horizontalen Querschnitt auf als die Mittelteile M (siehe Figur 2).

Anschließend wird Siliziumnitrid in einer Dicke von ca. 40nm abgeschieden und ca. 60nm weit anisotrop rückgeätzt, so daß die Mittelteile M teilweise freigelegt werden (siehe Figur 2). Aus dem Siliziumnitrid entstehen dadurch Spacer, die seitliche Flächen der Mittelteile M bedecken und erste Teile von Abstandhalter A bilden. Zweite Teile der Abstandhalter A bilden übrig bleibende Teile der Stopschicht S (siehe Figur 2). Eine obere Oberfläche der zweiten Teile der Abstandhalter A liegt ca. 20nm unterhalb der oberen Oberfläche der Stopschicht S.

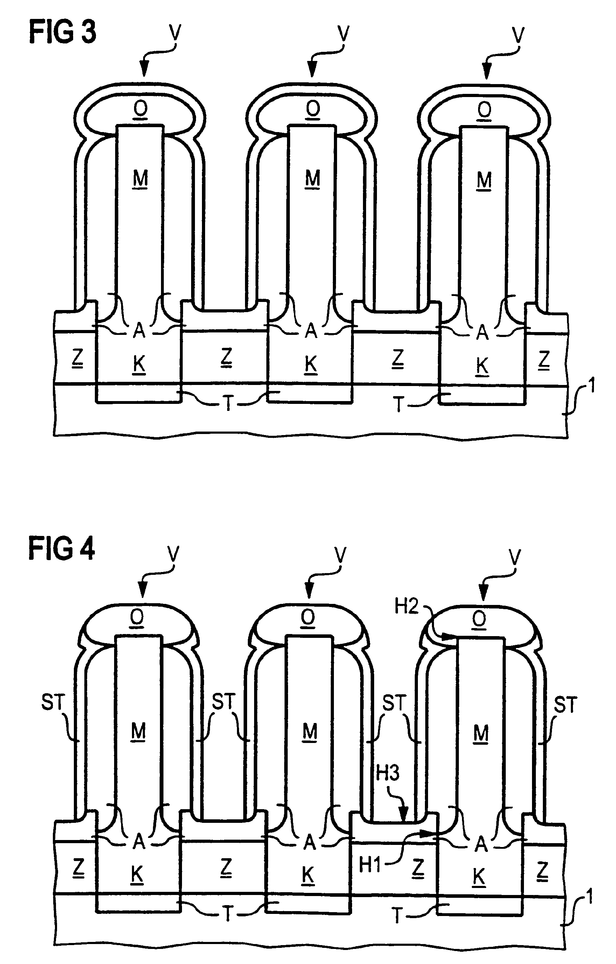

Durch selektive Epitaxie von Wolfram werden ca. 40nm dicke obere Teile O der ersten Kondensatorelektroden erzeugt, die auf den Mittelteilen M angeordnet sind und jeweils ca. 40nm seitlich vom darunter angeordneten Mittelteil M herausragen (siehe Figur 3).

Anschließend wird Wolfram in einer Dicke von ca. 15nm abgeschieden (siehe Figur 3).

Zur Erzeugung von Seitenteilen ST der ersten Kondensatorelektroden wird Wolfram 15nm tief anisotrop rückgeätzt, bis die zweiten Teile der Abstandhalter A freigelegt werden (siehe Figur 4). Die Seitenteile ST grenzen an die ersten Teile der Abstandhalter A an und sind auf den zweiten Teilen der Abstandhalter A angeordnet. Die Abstandhalter A sind unter den oberen Teilen O angeordnet. Die ersten Teile der Abstandhalter A sind zwischen den Mittelteilen M und den Seitenteilen ST angeordnet. Die Seitenteile ST erstrecken sich von einer dritten Höhe H3, bei der die obere Oberfläche der zweiten Teile der Abstandhalter A liegt, bis zur zweiten Höhe H2. Die Seitenteile ST umgeben jeweils den zugehörigen Mittelteil M seitlich.

Anschließend werden die Abstandhalter A entfernt, indem Siliziumnitrid selektiv zu SiO₂ und Wolfram isotrop mit z. B. heißer Phosphorsäure geätzt wird.

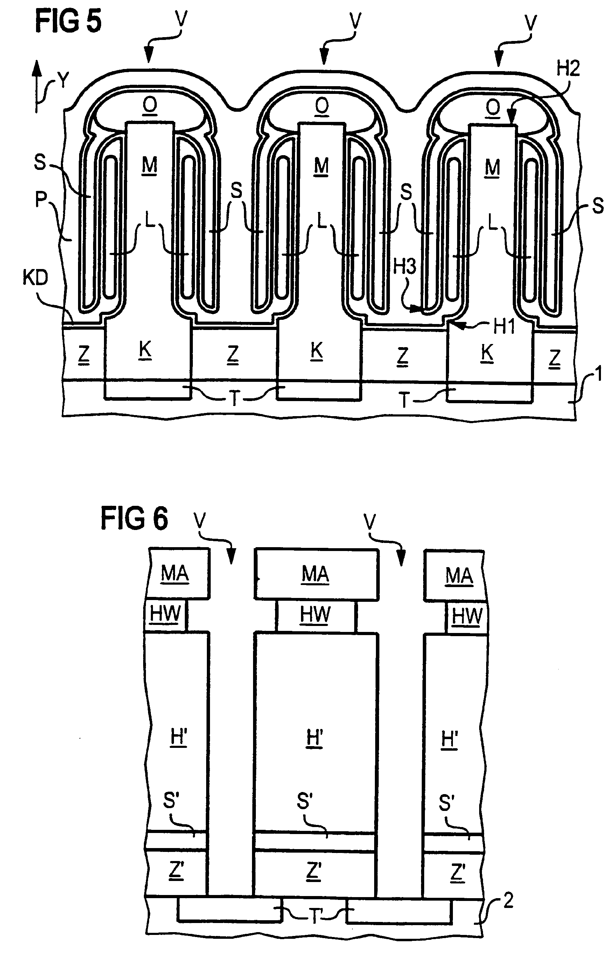

Zur Erzeugung eines Kondensatordielektrikums KD wird Ta₂O₅ oder Al₂O₃ in einer Dicke von ca. 10nm abgeschieden (siehe Figur 5).

Zur Erzeugung einer gemeinsamen zweiten Kondensatorelektrode P wird Titan oder Titannitrid in einer Dicke von ca. 100 nm abgeschieden (siehe Figur 5). Zwischen den Mittelteilen M und den Seitenteilen S entstehen Leerräume L (siehe Figur 5).

Mit dem beschriebenen Verfahren wird eine DRAM-Zellenanordnung erzeugt, bei der eine Speicherzelle einen der Transistoren T und einen damit verbundenen Kondensator, der aus einer ersten Kondensatorelektrode, dem Kondensatordielektrikum KD und der zweiten Kondensatorelektrode P besteht. Die Kondensatoren sind in Reihen und Spalten angeordnet. Eine Breite des Mittelteils M, die parallel zu der Richtung der Reihen ist, beträgt 50nm. Ein Abstand zwischen Mittelteilen M von Kondensatoren, die entlang der Reihen zueinander benachbart sind, beträgt 150nm. Dieselben Werte gelten entsprechend für die Länge des Mittelteils M, die parallel zu der Richtung der Spalten ist und für den Abstand zwischen Mittelteilen M von Kondensatoren, die entlang der Spalten zueinander benachbart sind. In diesen Verfahren ist die minimale, in der verwendeten Technologie herstellbare Strukturgröße F 100nm. Der Platzbedarf pro Speicherzelle beträgt folglich 4F².

In einem zweiten Ausführungsbeispiel ist als Ausgangsmaterial ein zweites Substrat 2 aus Silizium vorgesehen. Im Bereich einer Oberfläche des zweiten Substrats 2 werden Transistoren T' gemäß dem Stand der Technik erzeugt. Darüber wird ein ca. 200 nm dickes Zwischenoxid Z' aus SiO₂ erzeugt (siehe Figur 6). Darüber wird eine ca. 30 nm dicke Stopschicht S' aus Siliziumnitrid erzeugt. Darüber wird eine ca. 800 nm dicke Hilfsschicht H' aus Polysilizium erzeugt. Darüber wird eine ca. 50 nm dicke weitere Hilfsschicht HW aus Siliziumnitrid erzeugt. Darüber wird eine ca. 100 nm dicke Maskenschicht MA aus SiO₂ erzeugt (siehe Figur 6).

Es wird eine erste Photolackmaske (nicht dargestellt) erzeugt und mit Hilfe eines photolithographischen Verfahrens so strukturiert, daß sie kreisförmige Öffnungen mit einem Durchmesser von ca. 100nm aufweist, die in Reihen und Spalten angeordnet sind. Durch Abscheiden von Photolack in einer Dicke von ca. 25nm und Rückätzen, bis die Maskenschicht MA freigelegt wird, werden die Öffnungen in der Photolackmaske verkleinert, das heißt die Photolackmaske wird vergrößert. Mit Hilfe der vergrößerten Photolackmaske werden Vertiefungen V' erzeugt, die die Maskenschicht MA und die weitere Hilfsschicht HW durchtrennen und bis zur Hilfsschicht H' reichen.

Durch isotropes Ätzen von Siliziumnitrid selektiv zu SiO₂ werden die Vertiefungen V' im Bereich der weiteren Hilfsschicht HW erweitert, so daß ihre Durchmesser dort ca. 100nm betragen.

Anschließend wird Polysilizium mit z.B. SF₆ und Siliziumnitrid und SiO₂ mit z. B. CF₄ + CHF₃ anisotrop geätzt, so daß die Vertiefungen V' vertieft werden und bis zu Transistoren T' reichen (siehe Figur 6). Die erste Photolackmaske wird entfernt.

Durch Abscheiden und Rückätzen von Photolack werden die Vertiefungen V' mindestens so weit gefüllt, daß das Zwischenoxid Z' nicht freiliegt. Anschließend wird SiO₂ isotrop und selektiv zu Siliziumnitrid und Polysilizium geätzt, so daß die Maskenschicht MA entfernt wird. Der Photolack wird anschließend wieder entfernt.

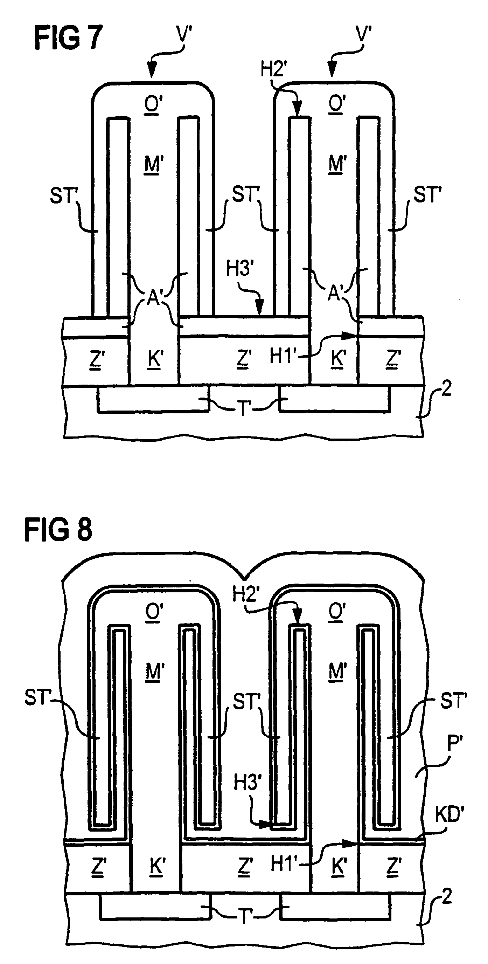

Durch Abscheiden von Wolfram in einer Dicke von ca. 100 nm und chemisch-mechanischem Polieren, bis die weitere Hilfsschicht HW freigelegt wird, werden in den Vertiefungen V' im Bereich der Hilfsschicht H' und der Stopschicht S' Mittelteile M' von ersten Kondensatorelektroden von Kondensatoren, darunter Kontakte K', die die Mittelteile M' mit den Transistoren T' verbinden, und im Bereich der weiteren Hilfsschicht HW erste Teile von oberen Teilen O' der ersten Kondensatorelektroden erzeugt (siehe Figur 7).

Anschließend wird Siliziumnitrid durch nasses Ätzen mit z. B. heißer Phosphorsäure geätzt, so daß die weitere Hilfsschicht HW entfernt wird. Polysilizium wird anisotrop geätzt, wobei die ersten Teile der oberen Teile 0' als Maske wirken. Dabei wird die Stopschicht S' freigelegt (siehe Figur 7).

Unter den ersten Teile der oberen Teile O' angeordnete Teile der Hilfsschicht H' bilden erste Teile von Abstandhalter A', die an seitlichen Flächen der Mittelteile M' angrenzen. Zweite Teile der Abstandhalter A' werden durch übrig bleibende Teile der Stopschicht S' gebildet, die seitlich von den Mittelteilen M' weg herausragen.

Zur Erzeugung von zweiten Teilen der oberen Teile O' und von Seitenteilen ST' der ersten Kondensatorelektroden wird Wolfram in einer Dicke von ca. 15 nm abgeschieden und rückgeätzt, bis die zweiten Teile der Abstandhalter A', das heißt die Stopschicht S', freigelegt werden (siehe Figur 7).

Durch nasses Ätzen von Siliziumnitrid und Polysilizium selektiv zu Wolfram und SiO₂ werden die Abstandhalter A' entfernt.

Zur Erzeugung eines Kondensatordielektrikums KD' wird Ta₂O₅ in einer Dicke von ca. 10 nm abgeschieden. Zur Erzeugung einer gemeinsamen zweiten Kondensatorelektrode P' der Kondensatoren wird Titan in einer Dicke von ca. 100 nm abgeschieden (siehe Figur 8).

Durch das beschriebene Verfahren wird eine DRAM-Zellenanordnung erzeugt, bei der Speicherzellen einen der Transistoren T' und einen damit verbundenen der Kondensatoren umfaßt. Die Mittelteile M' erstrecken sich von einer ersten Höhe H1', auf der eine untere Oberfläche der Stopschicht S' liegt, bis zu einer zweiten Höhe H2', die ca. 830 nm darüber liegt. Die Seitenteile ST' erstrecken sich von einer dritten Höhe H3', bei der eine obere Oberfläche der Stopschicht S' liegt, bis zur zweiten Höhe H2'. Die oberen Teile O' sind auf den Seitenteilen ST' und den Mittelzeilen M' angeordnet.

In einem dritten Ausführungsbeispiel ist als Ausgangsmaterial ein drittes Substrat 3 aus Silizium vorgesehen.

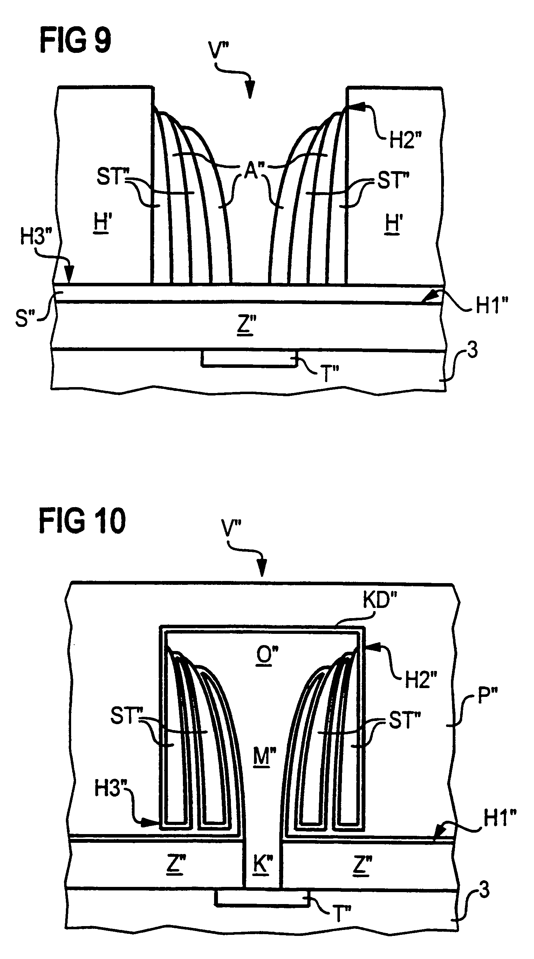

Wie im ersten Ausführungsbeispiel werden Transistoren T", ein Zwischenoxid Z", eine Stopschicht S", eine Hilfsschicht H und Vertiefungen V" erzeugt (siehe Figur 9). Im Gegensatz zu dem ersten Ausführungsbeispiel reichen die Vertiefungen V" nur bis zur Stopschicht S" und weisen einen quadratischen horizontalen Querschnitt mit einer Seitenlänge von ca. 300nm auf. Die Hilfsschicht H ist im Gegensatz zu ersten Ausführungsbeispiel ca. 850nm dick. Eine obere Oberfläche des Zwischenoxids Z" liegt bei einer ersten Höhe H1".

Es wird eine ca. 30nm dicke erste Schicht aus Wolfram abgeschieden und ca. 80nm weit rückgeätzt, so daß in den Vertiefungen V" jeweils ein erster Seitenteil S" einer ersten Kondensatorelektrode eines Kondensators erzeugt wird.

Es wird eine ca. 30nm dicke erste Schicht aus Siliziumnitrid abgeschieden und ca. 110nm weit rückgeätzt, so daß in den Vertiefungen V" jeweils ein erster Teil eines Abstandhalters A" erzeugt wird.

Es wird eine ca. 30nm dicke zweite Schicht aus Wolfram abgeschieden und ca. 110nm weit rückgeätzt, so daß in den Vertiefungen V" jeweils ein zweiter Seitenteil S" der ersten Kondensatorelektrode erzeugt wird.

Es wird eine ca. 30nm dicke zweite Schicht aus Siliziumnitrid abgeschieden und ca. 140nm weit rückgeätzt, so daß in den Vertiefungen V" jeweils ein zweiter Teil des Abstandhalters A" erzeugt wird.

Der erste Seitenteil ST" erstreckt sich von einer dritten Höhe H3", die bei einer oberen Oberfläche der Stopschicht S" liegt, bis zu einer zweiten Höhe H2", die ca. 800nm oberhalb der dritten Höhe und ca. 50nm unterhalb der Oberfläche der Hilfsschicht H liegt (siehe Figur 9).

Freigelegte Teile der Böden der Vertiefungen V" werden geätzt. Dabei werden die Stopschicht S" und das Zwischenoxid Z" durchtrennt, so daß die Transistoren T" freigelegt werden. Übrigbleibende Teile der Stopschicht S" bilden zweite Teile der Abstandhalter A".

Anschließend wird Wolfram in einer Dicke von ca. 140nm abgeschieden und chemisch-mechanisch poliert, bis außerhalb der Vertiefungen V" angeordnete Teile des Wolframs entfernt werden. Aus dem Wolfram entstehen in den Vertiefungen V" im Bereich oberhalb des Zwischenoxids Mittelteile M" der ersten Kondensatorelektroden, die von den innersten ersten Teilen der Abstandhalter A" umgeben werden, und obere Teile O" der ersten Kondensatorelektroden, die auf den Seitenteilen ST", den ersten Teilen der Abstandhalter A" und den Mittelteilen M" angeordnet sind. Im Bereich des Zwischenoxids Z" entstehen in den Vertiefungen V" aus dem Wolfram Kontakte K", die die Transistoren T" mit den ersten Kondensatorelektroden verbinden (siehe Figur 10).

Die Hilfsschicht H wird entfernt.

Wie im ersten Ausführungsbeispiel werden die Abstandhalter A" durch nasses Ätzen entfernt und ein Kondensatordielektrikum KD" und eine gemeinsame zweite Kondensatorelektrode P" der Kondensatoren erzeugt (siehe Figur 10).

Durch das beschriebene Verfahren wird eine DRAM-Zellenanordnung erzeugt, bei der Speicherzellen einen der Transistoren T" und einen damit verbundenen der Kondensatoren umfaßt.

Es sind viele Variationen der Ausführungsbeispiele denkbar, die ebenfalls im Rahmen der Erfindung liegen. Beispielsweise können Abmessungen der beschriebenen Schichten, Abstandhalter und Teile an die jeweiligen Erfordernisse angepaßt werden. Dasselbe gilt für die Wahl der Materialien.

## Patentansprüche

1. Verfahren zur Erzeugung einer integrierten Schaltungsanordnung mit mindestens einem Kondensator,
- bei dem der Kondensator über einer Oberfläche eines Substrats (1) erzeugt wird,
- bei dem eine y-Achse (y) senkrecht zur Oberfläche des Substrats (1) verläuft,
- bei dem ein Mittelteil (M) einer ersten Kondensatorelektrode des Kondensators so erzeugt wird, daß er sich von einer ersten Höhe (H1) bis zu einer darüber befindlichen zweiten Höhe (H2) bezüglich der y-Achse (y) erstreckt,
- bei dem ein Bauelement der integrierten Schaltungsanordnung erzeugt wird und mit dem darüber erzeugten Mittelteil (M) verbunden wird,
- bei dem mindestens ein Seitenteil (ST) der ersten Kondensatorelektrode so erzeugt wird, dass er neben dem Mittelteil (M) angeordnet ist und von ihm beabstandet ist,
- bei dem der Seitenteil (ST) so erzeugt wird, dass er sich von einer dritten Höhe (H3), die zwischen der ersten Höhe (H1) und der zweiten Höhe (H2) liegt, bis zur zweiten Höhe (H2) erstreckt,
- bei dem ein oberer Teil (O) der ersten Kondensatorelektrode so erzeugt wird, dass er auf dem Seitenteil (ST) und dem Mittelteil (M) angeordnet ist und diese miteinander verbindet,
- bei dem die erste Kondensatorelektrode mit einem Kondensatordielektrikum (KD) versehen wird, und
- bei der eine zweite Kondensatorelektrode (P) so erzeugt wird, dass sie an das Kondensatordielektrikum (KD) angrenzt,
**dadurch gekennzeichnet, daß**
- der Mittelteil (M) erzeugt wird, indem in einer auf dem Substrat (1) aufgetragenen Hilfsschicht (H) eine Vertiefung (V) gebildet wird und zumindest teilweise mit leitendem Material gefüllt wird,
- die Hilfsschicht (H) nach Erzeugung des Mittelteils (M) nicht tiefer als bis zur dritten Höhe (H₃) geätzt wird,
- durch Abscheiden und Rückätzen von Material als Teil eines Abstandhalters (A) ein Spacer an freiliegenden Teilen der seitlichen Flächen des Mittelteils (M) erzeugt wird, der maximal bis zur zweiten Höhe (H2) reicht,
- leitendes Material durch selektive Epitaxie aufgewachsen wird, so daß das Material auf dem Mittelteil (M) aber nicht auf dem Abstandhalter (A) aufwächst,
- weiteres leitendes Material im wesentlichen konform abgeschieden wird, und
- das leitende Material rückgeätzt wird, so daß aus dem leitenden Material der obere Teil (O) und der Seitenteil (ST) erzeugt werden und der Teil des Abstandhalters (A), der seitlich unter dem Seitenteil (ST) herausragt, teilweise freigelegt wird.

2. Verfahren nach Anspruch 1,
**dadurch gekennzeichnet, daß**
die dritte Höhe (H3) näher zur ersten Höhe (H1) als zur zweiten Höhe (H2) liegt.

3. Verfahren nach Anspruch 1 oder 2,
**dadurch gekennzeichnet, daß**
- der Abstandhalter (A) so gebildet wird, daß er an seitliche Flächen des Mittelteils (M) angrenzt und im Bereich der dritten Höhe (H3) seitlich vom Mittelteil (M) weg herausragt,
- der obere Teil (O) so erzeugt wird, daß er von oben an den Abstandhalter (A) angrenzt,
- der Seitenteil (ST) so erzeugt wird, daß er seitlich an dem Abstandhalter (A) angrenzt und auf dem Teil des Abstandhalters (A), der im Bereich der dritten Höhe (H3) seitlich vom Mittelteil (M) weg herausragt, angeordnet ist,
- der Abstandhalter (A) durch isotropes Ätzen entfernt wird, und
- anschließend das Kondensatordielektrikum (KD) und die zweite Kondensatorelektrode (P) erzeugt werden.

4. Verfahren nach einem der Ansprüche 1 bis 3,
**dadurch gekennzeichnet, dass**
- die erste Kondensatorelektrode im wesentlichen aus Wolfram oder Wolframsilizid erzeugt wird.

5. Verfahren nach einem der Ansprüche 1 bis 4,
**dadurch gekennzeichnet, dass**
- nach Ätzen der Hilfsschicht (H) der Mittelteil (M) durch isotropes Ätzen verengt wird.

6. Verfahren nach einem der Ansprüche 1 bis 5,
**dadurch gekennzeichnet, dass**
- auf der Hilfsschicht (H') eine weitere Hilfsschicht (HW) erzeugt wird,
- die Vertiefung (V') die weitere Hilfsschicht (HW) durchtrennt
- nach Erzeugen der Vertiefung (V') die weitere Hilfsschicht (HW) isotrop geätzt wird, so daß die Vertiefung (V') im Bereich der weiteren Hilfsschicht (HW) erweitert wird,
- durch Füllen der Vertiefung (V') mit dem leitenden Material der Mittelteil (M') im Bereich der Hilfsschicht (H') und ein erster Teil des oberen Teils (O') im Bereich der weiteren Hilfsschicht (HW) erzeugt werden,
- die weitere Hilfsschicht (HW) und die Hilfsschicht (H') selektiv zum ersten Teil des oberen Teils (O') anisotrop bis zur dritten Höhe (H3') geätzt werden, so daß unter dem ersten Teil des oberen Teils (O') aus der Hilfsschicht (H') mindestens ein Teil des Abstandhalters (A') gebildet wird, und
- der Seitenteil (ST') und ein zweiter Teil des oberen Teils (O') in Form des Spacers durch Abscheiden und Rückätzen von Material erzeugt werden, wobei seitlich an den ersten Teil des oberen Teils (O') angrenzende Teile des Spacers den zweiten Teil des oberen Teils (O') bilden.

7. Verfahren nach Anspruch 6,
**dadurch gekennzeichnet, dass**
- auf der weiteren,Hilfsschicht (HW) eine Maskenschicht (MA) erzeugt wird, die durch die Vertiefung (V') durchtrennt wird, und
- daß die Maskenschicht (MA) nach dem isotropen Ätzen der weiteren Hilfsschicht (HW) und vor dem Füllen der Vertiefung (V') entfernt wird.

8. Verfahren nach einem der Ansprüche 1 bis 5,
**dadurch gekennzeichnet, dass**
- die Hilfsschicht (H) mit einer solchen Dicke erzeugt wird, daß ihre obere Oberfläche höher als die zweite Höhe (H2") liegt,
- nach Erzeugung der Vertiefung (V") mindestens eine leitende Schicht abgeschieden und so rückgeätzt wird, daß in der Vertiefung (V") aus der leitenden Schicht der Seitenteil (ST") erzeugt wird,
- nach Erzeugung des Seitenteils (ST") mindestens eine isolierende Schicht abgeschieden und so rückgeätzt wird, daß in der Vertiefung (V") aus der isolierenden Schicht ein Teil des Abstandhalters (A"), der seitlich an den Seitenteil (ST") angrenzt, erzeugt wird,
- ein freigelegter Teil des Bodens der Vertiefung (V") bis mindestens zur ersten Höhe (H1") tiefer geätzt wird,
- noch nicht gefüllte Teile der Vertiefung (V") mit leitendem Material gefüllt werden, so daß aus einem Teil des leitenden Materials, der vom Abstandhalter (A") umgeben wird, der Mittelteil (M") gebildet wird und aus einem Teil des leitenden Materials, der auf dem Seitenteil (ST"), auf dem Abstandhalter (A") und auf dem Mittelteil (M") angeordnet ist, der obere Teil (O") gebildet wird.

9. Verfahren nach einem der Ansprüche 1 bis 8,
**dadurch gekennzeichnet, daß**
- über dem Substrat (1) eine Stopschicht (S) erzeugt wird, deren obere Fläche in der dritten Höhe (H3) liegt,
- die Hilfsschicht (H) auf der Stopschicht (S) erzeugt wird,
- die Vertiefung (V) die Stopschicht (S) durchtrennt,
- die Stopschicht (S) Teil des Abstandhalters (A) ist, und
- die Stopschicht (S) als Ätzstop beim Ätzen der Hilfsschicht (H) und des leitenden Materials des Seitenteils (ST) bis zur dritten Höhe (H3) dient.

10. Verfahren nach einem der Ansprüche 1 bis 9,
**dadurch gekennzeichnet,**
**daß** als Bauelement ein Transistor (T) erzeugt wird, der zusammen mit dem Kondensator eine Speicherzelle einer DRAM-Zellenanordnung bildet, und
**daß** die Kondensatoren von Speicherzellen der DRAM-Zellenanordnung so erzeugt werden, daß sie in Reihen und Spalten angeordnet sind.

11. Verfahren nach einem der Ansprüche 1 bis 10,
**dadurch gekennzeichnet,**
**daß** mindestens ein weiterer Seitenteil (ST") erzeugt wird, der einen anderen Abstand zum Mittelteil (M") aufweist als der Seitenteil (ST").

## Claims

1. Method for producing an integrated circuit arrangement with at least one capacitor,
- in which the capacitor is produced above a surface of a substrate (1),
- in which a y-axis (y) runs perpendicularly to the surface of the substrate (1),
- in which a central part (M) of a first capacitor electrode of the capacitor is produced in such a way that it extends from a first height (H1) as far as at a second height (H2) situated above the latter, with respect to the y-axis (y),
- in which a component of the integrated circuit arrangement is produced and is connected to the central part (M) produced above it,
- in which at least one side part (ST) of the first capacitor electrode is produced in such a way that it is arranged beside the central part (M) and is spaced apart from the latter,
- in which the side part (ST) is produced in such a way that it extends from a third height (H3) which lies between the first height (H1) and the second height (H2), as far as the second height (H2),
- in which an upper part (O) of the first capacitor electrode is produced in such a way that it is arranged on the side part (ST) and the central part (M) and connects these to one another,
- in which the first capacitor electrode is provided with a capacitor dielectric (KD), and
- in which a second capacitor electrode (P) is produced in such a way that it adjoins the capacitor dielectric (KD),
**characterized in that**
- the central part (M) is produced by forming a depression (V) in an auxiliary layer (H) applied on the substrate (1) and filling said depression at least partly with conductive material,
- after the production of the central part (M), the auxiliary layer (H) is etched no deeper than as far as the third height (H3),
- by depositing and etching back material as part of a spacing means (A), a spacer is produced on uncovered parts of the lateral areas of the central part (M), which spacer reaches at most as far as the second height (H2),
- conductive material is grown by selective epitaxy, so that the material grows on the central part (M) but not on the spacing means (A),
- further conductive material is deposited essentially conformally, and
- the conductive material is etched back, so that the upper part (0) and the side part (ST) are produced from the conductive material and the part of the spacing means (A) which projects laterally below the side part (ST) is partly uncovered.

2. Method according to Claim 1,
**characterized in that**
the third height (H3) is nearer to the first height (H1) than to the second height (H2).

3. Method according to Claim 1 or 2,
**characterized in that**
- the spacing means (A) is formed in such a way that it adjoins lateral areas of the central part (M) and projects laterally away from the central part (M) in the region of the third height (H3),
- the upper part (0) is produced in such a way that it adjoins the spacing means (A) from above,
- the side part (ST) is produced in such a way that it laterally adjoins the spacing means (A) and is arranged on the part of the spacing means (A) which projects laterally away from the central part (M) in the region of the third height (H3),
- the spacing means (A) is removed by isotropic etching, and
- the capacitor dielectric (KD) and the second capacitor electrode (P) are subsequently produced.

4. Method according to one of Claims 1 to 3,
**characterized in that**
- the first capacitor electrode is essentially produced from tungsten or tungsten silicide.

5. Method according to one of Claims 1 to 4,
**characterized in that**
- after the etching of the auxiliary layer (H), the central part (M) is narrowed by isotropic etching.

6. Method according to one of Claims 1 to 5,
**characterized in that**
- a further auxiliary layer (HW) is produced on the auxiliary layer (H'),
- the depression (V') cuts through the further auxiliary layer (HW),
- after the production of the depression (V'), the further auxiliary layer (HW) is etched isotropically, thereby extending the depression (V') in the region of the further auxiliary layer (HW),
- by filling the depression (V') with the conductive material, the central part (M') is produced in the region of the auxiliary layer (H') and a first part of the upper part (O') is produced in the region of the further auxiliary layer (HW),
- the further auxiliary layer (HW) and the auxiliary layer (H') are etched selectively with respect to the first part of the upper part (O') anisotropically as far as the third height (H3'), so that at least one part of the spacing means (A') is formed from the auxiliary layer (H') below the first part of the upper part (O'), and
- the side part (ST') and a second part of the upper part (O') are produced in the form of the spacer by depositing and etching back material, parts of the spacer which laterally adjoin the first part of the upper part (O') forming the second part of the upper part (O').

7. Method according to Claim 6,
**characterized in that**
- a mask layer (MA) is produced on the further auxiliary layer (HW), which mask layer is cut through by the depression (V'), and
- **in that** the mask layer (MA) is removed after the isotropic etching of the further auxiliary layer (HW) and before the filling of the depression (V').

8. Method according to one of Claims 1 to 5,
**characterized in that**
- the auxiliary layer (H") is produced with a thickness such that its upper surface lies higher than the second height (H2"),
- after the production of the depression (V"), at least one conductive layer is deposited and etched back in such a way that the side part (ST") is produced from the conductive layer in the depression (V"),
- after the production of the side part (ST"), at least one insulating layer is deposited and etched back in such a way that a part of the spacing means (A") which laterally adjoins the side part (ST") is produced from the insulating layer in the depression (V"),
- an uncovered part of the bottom of the depression (V") is etched more deeply at least as far as the first height (H1"),
- as yet unfilled parts of the depression (V") are filled with conductive material, so that the central part (M") is formed from a part of the conductive material which is surrounded by the spacing means (A") and the upper part (O") is formed from a part of the conductive material which is arranged on the side part (ST"), on the spacing means (A") and on the central part (M").

9. Method according to one of Claims 1 to 8,
**characterized in that**
- a stop layer (S) is produced above the substrate (1), the upper area of which stop layer lies at the third height (H3),
- the auxiliary layer (H) is produced on the stop layer (S),
- the depression (V) cuts through the stop layer (S),
- the stop layer (S) is part of the spacing means (A), and
- the stop layer (S) serves as an etching stop during the etching of the auxiliary layer (H) and of the conductive material of the side part (ST) as far as the third height (H3).

10. Method according to one of Claims 1 to 9,
**characterized**
**in that** a transistor (T) is produced as the component, which transistor, together with the capacitor, forms a memory cell of a DRAM cell arrangement, and
**in that** the capacitors of memory cells of the DRAM cell arrangement are produced in such a way that they are arranged in rows and columns.

11. Method according to one of Claims 1 to 10,
**characterized**
**in that** at least one further side part (ST") is produced which has a different distance from the central part (M") than the side part (ST").

## Revendications

1. Procédé de production d'un circuit intégré ayant au moins un condensateur,
- dans lequel on produit le condensateur sur une surface d'un substrat (1) ;
- dans lequel un axe y (y) s'étend perpendiculairement à la surface du substrat (1) ;
- dans lequel on produit une partie (M) médiane d'une première électrode du condensateur de façon à ce qu'elle s'étende, par rapport à l'axe y (y), d'un premier niveau (H1) jusqu'à un deuxième niveau (H2) se trouvant au-dessus;
- dans lequel on produit un composant du circuit intégré et on le relie à la partie (M) médiane produite au-dessus ;
- dans lequel on produit au moins une partie (ST) latérale de la première électrode du condensateur de façon à ce qu'elle soit disposée à côté de la partie (M) médiane et à distance de celle-ci ;
- dans lequel on produit la partie (ST) latérale de manière à ce qu'elle s'étende d'un troisième niveau (H3) qui est compris entre le premier niveau (H1) et le deuxième niveau (H2) jusqu'au deuxième niveau (H2) ;
- dans lequel on produit une partie (O) supérieure de la première électrode du condensateur de façon à ce qu'elle soit disposée sur la partie (S2) latérale et la partie (M) médiane et les relie entre elles ;
- dans lequel la première électrode du condensateur est munie d'un diélectrique (KD) de condensateur ; et
- dans lequel on produit une deuxième électrode (P) de condensateur de manière à ce qu'elle soit voisine du diélectrique (KD) de condensateur,
**caractérisé en ce que**
- on produit la partie (M) médiane en formant une cavité (V) dans une couche (H) auxiliaire déposée sur le substrat (1) et on l'emplit au moins en partie de matériau conducteur ;
- on attaque la couche (H) auxiliaire après production de la partie (M) médiane jusqu'à une profondeur moindre que jusqu'au troisième niveau (H3) ;
- par dépôt et attaque en retrait de matériau, on produit comme partie d'une entretoise (A) un espaceur sur des parties mises à nu des surfaces latérales de la partie (M) médiane, qui va au maximum jusqu'au deuxième niveau (H2) ;
- on fait croître par épitaxie sélective du matériau conducteur, de sorte que le matériau croisse jusqu'à la partie (M) médiane, mais non sur l'entretoise (A) ;
- on dépose de manière sensiblement conforme du matériau conducteur supplémentaire ; et
- on attaque en retrait le matériau conducteur de manière à produire à partir du matériau conducteur la partie (O) supérieure et la partie (ST) latérale et on met à nu au moins partiellement la partie de l'entretoise (A) qui fait saillie latéralement en dessous de la partie (ST) latérale.

2. Procédé suivant la revendication 1,
**caractérisé en ce que**
le troisième niveau (H3) est plus près du premier niveau (H1) que du deuxième niveau (H2).

3. Procédé suivant la revendication 1 ou 2,
**caractérisé en ce que**
- on forme l'entretoise (A) de façon à ce qu'elle soit voisine de la surface latérale de la partie (M) médiane et de façon à ce qu'elle fasse saillie dans la partie du troisième niveau (H3) en s'éloignant latéralement de la partie (M) médiane ;
- on produit la partie (0) supérieure de manière à ce qu'elle soit voisine par le haut de l'entretoise (A) ;
- on produit la partie (ST) latérale de manière à ce qu'elle soit voisine latéralement de l'entretoise (A) et soit disposée sur la partie de l'entretoise (A) qui fait saillie dans la partie du troisième niveau (H3) latéralement de la partie (M) médiane en s'en éloignant ;
- on élimine l'entretoise (A) par attaque isotrope ; et
- on produit ensuite le diélectrique (KD) de condensateur et la deuxième électrode (P) de condensateur.

4. Procédé suivant l'une des revendications 1 à 3 ;
**caractérisé en ce que**
- on produit la première électrode de condensateur sensiblement en tungstène ou en siliciure de tungstène.

5. Procédé suivant l'une des revendications 1 à 4,
**caractérisé en ce que**
- après l'attaque de la couche (H) auxiliaire, on rétrécit la partie (M) médiane par attaque isotrope.

6. Procédé suivant l'une des revendications 1 à 5,
**caractérisé en ce que**
- on produit une autre couche (HW) auxiliaire sur la couche (H') auxiliaire ;
- la cavité (V') traverse l'autre couche (HW) auxiliaire ;
- après production de la cavité (V'), on attaque de façon isotrope l'autre couche (HW) auxiliaire de manière à élargir la cavité (V') dans la partie de l'autre couche (HW) auxiliaire ;
- en remplissant la cavité (V') de matériau conducteur, on produit la partie (M') médiane dans la partie de la couche (H') auxiliaire et une première partie de la partie (0') supérieure dans la partie de l'autre couche (HW) auxiliaire ;
- on attaque l'autre couche (HW) auxiliaire et la couche (H') auxiliaire sélectivement par rapport à la première partie de la partie (O') supérieure de façon anisotrope jusqu'au troisième niveau (H3') de façon à former en dessous de la première partie et de la partie (O') supérieure à partir de la couche (H') auxiliaire au moins une partie de l'entretoise (A') ; et
- on produit la partie (ST') latérale et une deuxième partie de la partie (O') supérieure sous la forme de l'espaceur par dépôt et attaque en retrait de matériau, des parties de l'espaceur voisines latéralement de la première partie de la partie (O') supérieure formant la deuxième partie de la partie (0') supérieure.

7. Procédé suivant la revendication 6,
**caractérisé**
- **en ce que** l'on produit sur l'autre couche (HW) auxiliaire une couche (MA) de masque, qui est traversée par la cavité (V') ; et
- **en ce que** l'on élimine la couche (MA) de masque après l'attaque isotrope de l'autre couche (HW) auxiliaire et avant le remplissage de la cavité (V').

8. Procédé suivant l'une des revendications 1 à 5,
**caractérisé en ce que**
- on produit la couche (H") auxiliaire en une épaisseur telle que sa surface supérieure est plus haute que le deuxième niveau (H2') ;
- après production de la cavité (V"), on dépose et on attaque en retrait au moins une couche conductrice de façon à produire la partie (ST") latérale dans la cavité (V") à partir de la couche conductrice ;
- après production de la partie (ST") latérale on dépose et on attaque en retrait au moins une couche isolante de façon à produire dans la cavité (V"), à partir de la couche isolante, une partie de l'entretoise (A"), qui est voisine latéralement de la partie (ST") latérale ;
- on attaque assez profondément une partie mise à nu du fond de la cavité (V") jusqu'à au moins le premier niveau (H1') ;
- on emplit de matériau conducteur des parties de la cavité (V") qui ne sont pas encore remplies de manière à former à partir d'une partie du matériau conducteur qui est entourée de l'entretoise (A") la partie (M") médiane et à former la partie (O") supérieure à partir d'une partie du matériau conducteur qui est disposée sur la partie (ST") latérale sur l'entretoise (A") et sur la partie (M") médiane.

9. Procédé suivant l'une des revendications 1 à 8,
**caractérisé en ce que**
- on produit sur le substrat (1) une couche (S) d'arrêt dont la surface se trouve au troisième niveau (H3) ;
- on produit la couche (H) auxiliaire sur la couche (S) d'arrêt ;
- la cavité (V) traverse la couche (S) d'arrêt ;
- la couche (S) d'arrêt fait partie de l'entretoise (A) ; et
- la couche (S) d'arrêt sert d'arrêt d'attaque lors de l'attaque de la couche (H) auxiliaire et du matériau conducteur de la partie (ST) latérale jusqu'au troisième niveau (H3).

10. Procédé suivant l'une des revendications 1 à 9,
**caractérisé**
**en ce que** l'on produit comme composant un transistor (T) qui forme, ensemble avec le condensateur, une cellule de mémoire d'un dispositif de cellules DRAM ; et
**en ce que** l'on produit les condensateurs des cellules de mémoire du dispositif de cellules DRAM de façon à ce qu'ils soient disposés en lignes et en colonnes.

11. Procédé suivant l'une des revendications 1 à 10,
**caractérisé**
**en ce que** l'on produit au moins une autre partie (ST") latérale qui a une distance à la partie (M") médiane autre que la partie (ST") latérale.
